# EUROPEAN PATENT APPLICATION

(11) **EP 1 990 843 A1**
(43) Date of publication of application: **12.11.2008**
(21) Application number: 07737478.3
(22) Date of filing: 28.02.2007
(51) Int. Cl.: H01L 51/50, C09K 11/06

(54) **ORGANIC ELECTROLUMINESCENT DEVICE USING FLUORANTHENE DERIVATIVE AND INDENOPERYLENE DERIVATIVE**

(30) Priority: 28.02.2006 JP 2006053992
(71) Applicant: Idemitsu Kosan Co., Ltd., Chiyoda-ku Tokyo 100-8321 (JP)
(72) Inventor: SADO, Takayasu, Chiba 299-0293 (JP); IKEDA, Kiyoshi, Chiba 299-0293 (JP); ARAKANE, Takashi, Chiba 299-0293 (JP); HOSOKAWA, Chishio, Chiba 299-0293 (JP)
(74) Representative: Gille Hrabal Struck Neidlein Prop Roos
(86) International application number: PCT/JP2007/053721
(87) International publication number: WO 2007/099983

(57) **Abstract**

An organic electroluminescence device including an anode (20), a cathode (80), and at least an emitting layer (50) and an electron-transporting layer (60) provided between the anode (20) and the cathode (80); the emitting layer (50) containing a host material which is a fluoranthene derivative represented by the following formula (1) and a dopant material which is an indenoperylene derivative: 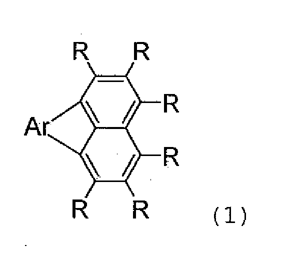 wherein Ar is a substituted or unsubstituted aromatic group having 6 to 50 ring carbon atoms; and Rs are independently a hydrogen atom, substituted or unsubstituted aromatic group having 6 to 50 ring carbon atoms, or substituted or unsubstituted alkyl group having 1 to 50 carbon atoms.

## Description

### TECHNICAL FIELD

The invention relations to a novel naphthacene derivative, a material for an organic electroluminescence (EL) device using a fluoranthene derivative and an indenoperylene derivative in combination.

### BACKGROUND

An organic EL device is a self-emission device by the use of the principle that a fluorescent material emits light by the recombination energy of holes injected from an anode and electrons injected from a cathode when an electric field is impressed.

Since C. W. Tang et al. of Eastman Kodak Co. reported a low-voltage driven organic EL device of stack type (Non-patent Document 1), studies on organic EL devices wherein organic materials are used as constituent materials has actively conducted.

Tang et al. uses tris(8-quinolinol) aluminum (Alq) for an emitting layer and a triphenyldiamine derivative for a hole-transporting layer in a stack structure. The advantages of the stack structure are to increase injection efficiency of holes to the emitting layer, to increase generation efficiency of excitons generated by recombination by blocking electrons injected in the cathode, to confine the generated excitons in the emitting layer, and so on. Like this example, as the structure of the organic EL device, a two-layered type of a hole-transporting (injecting) layer and an electron-transporting emitting layer, and a three-layered type of a hole-transporting (injecting) layer, an emitting layer and an electron-transporting (injecting) layer are widely known. In such stack structure devices, their device structures and fabrication methods have been contrived to increase recombination efficiency of injected holes and electrons.

As a luminescent material used in an organic EL device, there are known chelate complexes such as tris(8-quinolinol) aluminum complexes, coumarin complexes, tetrapenylbutadiene derivatives, bisstyrlarylene derivatives, oxadiazole derivatives and the like. They are reported to give emission in the visible range from blue to red, and are expected to realize color display devices (Patent documents 1 to 3, for example). However they do not have a practical luminous efficiency and lifetime. Further, full-color displays require three primary colors (blue, green, red), particularly a high efficient red device.

For example, Patent document 4 has recently disclosed a red luminescent device where a naphthacene or pentacene derivative is added in an emitting layer. This luminescent device is excellent in red purity but its applied voltage is high of 11 V and the halftime of luminance is insufficient of about 150 hours. Patent document 5 discloses a device where a dicyanomethylene (DCM) compound is added in an emitting layer but the red purity thereof is not satisfactory. Patent document 6 discloses a red luminescent device where an amine type aromatic compound is added in an emitting layer. This device has a good color purity of CIE chromaticity (0.64, 0.33), but the driven voltage is high. Patent documents 7 and 8 disclose devices using an amine type aromatic compound and Alq in an emitting layer. The device emits red light with low efficiency and short lifetime.

Patent document 9 discloses a device using an amine type aromatic compound and DPVDPAN in an emitting layer. The device emits orange light at a high efficiency but red light at a low efficiency.

Patent document 10 discloses a device where a dicyanoanthracene derivative and an indenoperylene derivative are used in an emitting layer, and a metal complex is used in an electron-transporting layer. However, the emission color thereof is reddish orange.

Patent document 11 discloses a device wherein a fluoranthene derivative and an indenoperylene derivative are used in an emitting layer, and a fluoranthene derivative is used in an electron-transporting layer; however, it does not have a practical efficiency.

[Patent document 1] JP-A-H8-239655
[Patent document 2] JP-A-H7-138561
[Patent document 3] JP-A-H3-200289
[Patent document 4] JP-A-H8-311442
[Patent document 5] JP-A-H3-162481
[Patent document 6] JP-A-2001-81451
[Patent document 7] WO01/23497
[Patent document 8] JP-A-2003-40845
[Patent document 9] JP-A-2003-81924
[Patent document 10] JP-A-2001-307885
[Patent document 11] JP-A-2003-338377
[Non-patent document 1] C.W. Tang, S.A. Vanslyke, Applied Physics Letters, 51, 913, 1987

An object of the invention is to provide a practical organic EL device and an organic EL device with a high efficiency, long lifetime and excellent color purity.

### Disclosure of the Invention

The inventors made extensive studies to attain the above object, and have found that the lifetime and efficiency of an organic EL device can be enhanced by using a fluoranthene derivative and an indenoperylene derivative in an emitting layer. The invention has made based on the finding.
According to the invention, the following organic EL device and the like is provided.
1. An organic electroluminescence device comprising:
   an anode,
   a cathode, and
   at least an emitting layer and an electron-transporting layer provided between the anode and the cathode;
   the emitting layer containing a host material which is a fluoranthene derivative represented by the following formula (1) and a dopant material which is an indenoperylene derivative: 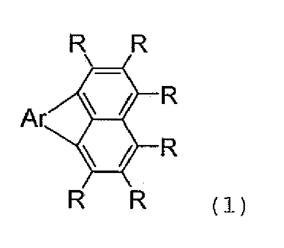 wherein Ar is a substituted or unsubstituted aromatic group having 6 to 50 carbon atoms that form a ring (ring carbon atoms); and Rs are independently a hydrogen atom, a substituted or unsubstituted aromatic group having 6 to 50 ring carbon atoms, a substituted or unsubstituted aromatic heterocyclic group having 5 to 50 atoms that form a ring (ring atoms), or a substituted or unsubstituted alkyl group having 1 to 50 carbon atoms.
2. The organic electroluminescence device according to 1 wherein the fluoranthene derivative is a compound represented by the following formula (2) or (3): 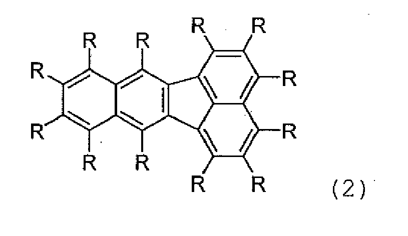 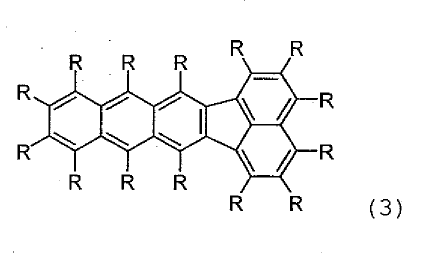 wherein Rs are independently a hydrogen atom, a substituted or unsubstituted aromatic group having 6 to 50 ring carbon atoms, a substituted or unsubstituted aromatic heterocyclic group having 5 to 50 ring atoms or a substituted or unsubstituted alkyl group having 1 to 50 carbon atoms.
3. The organic electroluminescence device according to 1 wherein the indenoperylene derivative is a compound represented by the following formula (4) or (5): 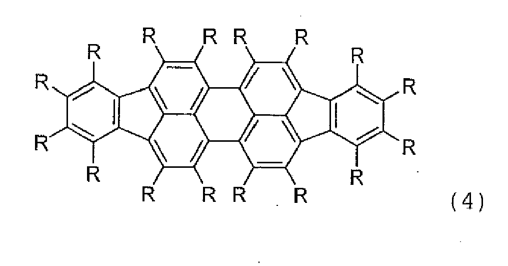 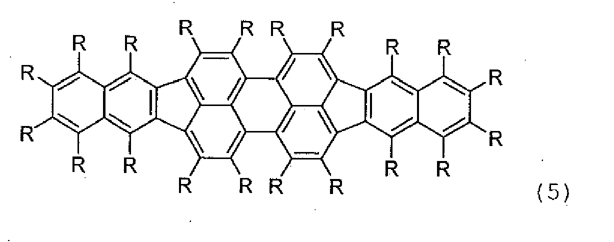 wherein Rs are independently a hydrogen atom, a substituted or unsubstituted aromatic group having 6 to 50 ring carbon atoms, a substituted or unsubstituted aromatic heterocyclic group having 5 to 50 ring atoms, or a substituted unsubstiuted alkyl group having 1 to 50 carbon atoms.
4. The organic electroluminescence device according to any one of 1 to 3 wherein the electron-transporting layer contains a compound represented by the following formula (6):

   (A)ᵤ-(B)ᵥ (6)

   wherein A is an aromatic hydrocarbon group with 3 or more carboncircles; B is a heterocyclic group which may be substituted; and u and v are each an integer of 1 to 6.
5. The organic electroluminescence device according to 4 wherein the compound represented by the formula (6) is a compound containing in the molecule thereof at least one skeleton selected from anthracene, phenanthrene, naphthacene, pyrene, chrysene, benzoanthracene, pentacene, dibenzoanthracene, benzopyrene, fluorene, benzofluorene, fluoranthene, benzofluoranthene, naphthofluoranthene, dibenzofluorene, dibenzopyrene and dibenzofluoranthene.
6. The organic electroluminescence device according to 4 or 5 wherein the compound represented by the formula (6) is a nitrogen-containing heterocyclic compound.
7. The organic electroluminescence device according to 6 wherein the nitrogen-containing heterocyclic compound is a compound containing in the molecule thereof at least one skeleton selected from pyridine, pyrimidine, pyrazine, pyridazine, triazine, quinoline, quinoxaline, acridine, imidazopyridine, imidazopyrimidine and phenenthroline.
8. The organic electroluminescence device according to 6 wherein the nitrogen-containing heterocyclic compound is a benzoimidazole derivative represented by the following formula (7) or (8): 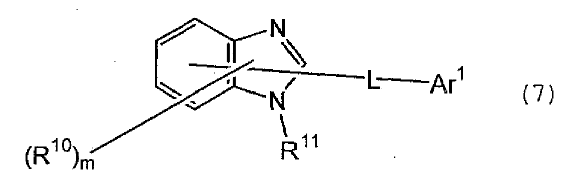 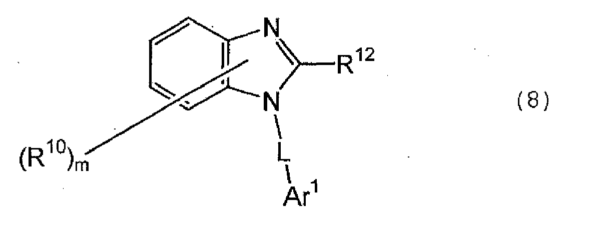 wherein R¹⁰ is a hydrogen atom, a substituted or unsubstituted aryl group having 6 to 60 carbon atoms, a substituted or unsubstituted pyridyl group, a substituted or unsubstituted quinolyl group, a substituted or unsubstituted alkyl group having 1 to 20 carbon atoms or a substituted or unsubstituted alkoxy group having 1 to 20 carbon atoms;
   m is an integer of 0 to 4;
   R¹¹ is a substituted or unsubstituted aryl group having 6 to 60 carbon atoms, a substituted or unsubstituted pyridyl group, a substituted or unsubstituted quinolyl group, a substituted or unsubstituted alkyl group having 1 to 20 carbon atoms or alkoxy group having 1 to 20 carbon atoms;
   R¹² is a hydrogen atom, a substituted or unsubstituted aryl group having 6 to 60 carbon atoms, a substituted or unsubstituted pyridyl group, a substituted or unsubstituted quinolyl group, a substituted or unsubstituted alkyl group having 1 to 20 carbon atoms, or a substituted or unsubstituted alkoxy group having 1 to 20 carbon atoms;
   L is a substituted or unsubstituted arylene group having 6 to 60 carbon atoms, a substituted or unsubstituted pyridinylene group, a substituted or unsubstituted quinoliylene group, or a substituted or unsubstituted fluorenylene group; and
   Ar¹ is a substituted or unsubstituted aryl group having 6 to 60 carbon atoms, a substituted or unsubstituted pyridinyl group or a substituted or unsubstituted quinolinyl group.
9. The organic electroluminescence device according to any one of 1 to 8 wherein the doping concentration of the dopant in the emitting layer is 0.1 to 10 wt%.
10. The organic electroluminescence device according to 9 wherein the doping concentration of the dopant in the emitting layer is 0.5 to 2 wt%.
11. The organic electroluminescence device according to any one of 1 to 10 whose emission color is orange to red.
12. An apparatus comprising the organic electroluminescet device of any one of 1 to 11.

According to the invention, a practical organic EL device with a high efficiency and long lifetime that is excellent in color purity can be provided.
According to the invention, an organic EL device with an even higher efficiency can be obtained by selecting compounds suitable for an electron-transporting layer and emitting layer. That is, an organic EL device with high color purity can be obtained where exciton generation in an electron-transporting layer is suppressed and therefore slight emission from the electron-transporting layer is further suppressed. The lifetime of the device can be extended for the same reasons.

### Brief Description of Drawing

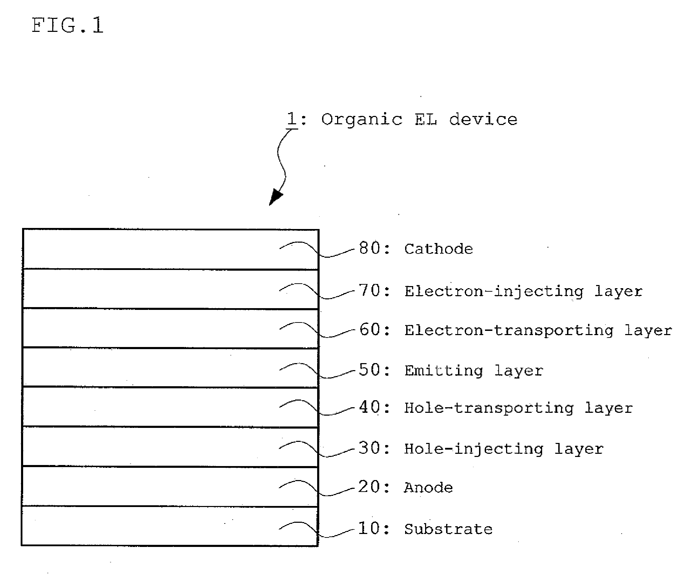

FIG. 1 is a view showing an embodiment according to an organic EL device of the invention.

### Best Mode for Carrying out the Invention

The fluoranthene derivative used in the invention is represented by the following formula (1).

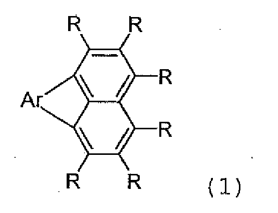

wherein Ar is substituted or unsubstituted aromatic group having 6 to 50 ring carbon atoms; and Rs are independently a hydrogen atom, substituted or unsubstituted aromatic group having 6 to 50 ring carbon atoms, substituted or unsubstituted aromatic heterocyclic group having 5 to 50 ring atoms, or substituted or unsubstituted alkyl group having 1 to 50 carbon atoms.

The unsubstituted aromatic group having 6 to 50 ring carbon atoms of Ar includes a phenyl group, (o-, m-, and p-) tolyl group, pyrenyl group, perylenyl group, coronenyl group, (1-, and 2-) naphthyl group, anthryl group, (o-, m-, and p-) biphenylyl group, terphenyl group, phenanthryl group or the like, and more preferably a (1-, and 2-) naphthyl group, anthryl group or the like.

Examples of the unsubstituted aryl group having 6 to 50 ring atoms include a phenyl group, 1-naphthyl group, 2-naphthyl group, 1-anthryl group, 2-anthryl group, 9-anthryl group, 1-phenanthryl group, 2-phenanthryl group, 3-phenanthryl group, 4-phenanthryl group, 9-phenanthryl group, 1-naphthacenyl group, 2-naphthacenyl group, 9-naphthacenyl group, 1-pyrenyl group, 2-pyrenyl group, 4-pyrenyl group, 2-biphenylyl group, 3-biphenylyl group, 4-biphenylyl group, p-terphenyl-4-yl group, p-terphenyl-3-yl group, p-terphenyl-2-yl group, m-terphenyl-4-yl group, m-terphenyl-3-yl group, m-terphenyl-2-yl group, o-tolyl group, m-tolyl group, p-tolyl group, and fluoranthenyl group.

When Rs are a substituted aromatic group having 6 to 50 ring carbon atoms, the substituent of the aromatic group includes a substituted or unsubstituted aryl group having 6 to 50 ring carbon atoms, substituted or unsubstituted aromatic heterocyclic group having 5 to 50 ring atoms, substituted or unsubstituted alkyl group having 1 to 50 carbon atoms, substituted or unsubstituted alkoxy group having 1 to 50 carbon atoms, substituted or unsubstituted aralkyl group having 1 to 50 carbon atoms, substituted or unsubstituted aryloxy group having 5 to 50 ring atoms, substituted or unsubstituted arylthio group having 5 to 50 ring atoms, substituted or unsubstituted carboxyl group having 1 to 50 carbon atoms, halogen group, cyano group, nitro group, hydroxy group and the like.

As examples of the substituted or unsubstituted aryl group having 6 to 50 ring carbon atoms, a phenyl group, 1-naphthyl group, 2-naphthyl group, 1-anthryl group, 2-anthryl group, 9-anthryl group, 1-phenanthryl group, 2-phenanthryl group, 3-phenanthryl group, 4-phenanthryl group, 9-phenanthryl group, 1-naphthacenyl group, 2-naphthacenyl group, 9-naphthacenyl group, 1-pyrenyl group, 2-pyrenyl group, 4-pyrenyl group, 2-biphenylyl group, 3-biphenylyl group, 4-biphenylyl group, p-terphenyl-4-yl group, p-terphenyl-3-yl group, p-terphenyl-2-yl group, m-terphenyl-4-yl group, m-terphenyl-3-yl group, m-terphenyl-2-yl group, o-tolyl group, m-tolyl group, p-tolyl group, p-t-butylphenyl group, p-(2-phenylpropyl)phenyl group, 3-methyl-2-naphthyl group, 4-methyl-1-naphthyl group, 4-methyl-1-anthryl group, 4'-methylbiphenylyl group, 4"-t-butyl-p-terphenyl-4-yl group, fluoranthenyl group, and the like can be given. Preferred are a phenyl group, 1-naphthyl group, 2-naphthyl group, 9-phenanthryl group, 1-naphthacenyl group, 2-naphthacenyl group, 9-naphthacenyl group, 1-pyrenyl group, 2-pyrenyl group, 4-pyrenyl group, 2-biphenylyl group, 3-biphenylyl group, 4-biphenylyl group, o-tolyl group, m-tolyl group, p-tolyl group, p-t-butylphenyl group or the like.

As examples of the substituted or unsubstituted aromatic heterocyclic group having 5 to 50 ring atoms, a 1-pyrrolyl group, 2-pyrrolyl group, 3-pyrrolyl group, pyrazinyl group, 2-pyridinyl group, 3-pyridinyl group, 4-pyridinyl group, 1-indolyl group, 2-indolyl group, 3-indolyl group, 4-indolyl group, 5-indolyl group, 6-indolyl group, 7-indolyl group, 1-isoindolyl group, 2-isoindolyl group, 3-isoindolyl group, 4-isoindolyl group, 5-isoindolyl group, 6-isoindolyl group, 7-isoindolyl group, 2-furyl group, 3-furyl group, 2-benzofuranyl group, 3-benzofuranyl group, 4-benzofuranyl group, 5-benzofuranyl group, 6-benzofuranyl group, 7-benzofuranyl group, 1-isobenzofuranyl group, 3-isobenzofuranyl group, 4-isobenzofuranyl group, 5-isobenzofuranyl group, 6-isobenzofuranyl group, 7-isobenzofuranyl group, quinolyl group, 3-quinolyl group, 4-quinolyl group, 5-quinolyl group, 6-quinolyl group, 7-quinolyl group, 8-quinolyl group, 1-isoquinolyl group, 3-isoquinolyl group, 4-isoquinolyl group, 5-isoquinolyl group, 6-isoquinolyl group, 7-isoquinolyl group, 8-isoquinolyl group, 2-quinoxalinyl group, 5-quinoxalinyl group, 6-quinoxalinyl group, 1-carbazolyl group, 2-carbazolyl group, 3-carbazolyl group, 4-carbazolyl group, 9-carbazolyl group, 1-phenanthridinyl group, 2-phenanthridinyl group, 3-phenanthridinyl group, 4-phenanthridinyl group, 6-phenanthridinyl group, 7-phenanthridinyl group, 8-phenanthridinyl group, 9-phenanthridinyl group, 10-phenanthridinyl group, 1-acridinyl group, 2-acridinyl group, 3-acridinyl group, 4-acridinyl group, 9-acridinyl group, 1,7-phenanthrolin-2-yl group, 1,7-phenanthrolin-3-yl group, 1,7-phenanthrolin-4-yl group, 1,7-phenanthrolin-5-yl group, 1,7-phenanthrolin-6-yl group, 1,7-phenanthrolin-8-yl group, 1,7-phenanthrolin-9-yl group, 1,7-phenanthrolin-10-yl group, 1,8-phenanthrolin-2-yl group, 1,8-phenanthrolin-3-yl group, 1,8-phenanthrolin-4-yl group, 1,8-phenanthrolin-5-yl group, 1,8-phenanthrolin-6-yl group, 1,8-phenanthrolin-7-yl group, 1,8-phenanthrolin-9-yl group, 1,8-phenanthrolin-10-yl group, 1,9-phenanthrolin-2-yl group, 1,9-phenanthrolin-3-yl group, 1,9-phenanthrolin-4-yl group, 1,9-phenanthrolin-5-yl group, 1,9-phenanthrolin-6-yl group, 1,9-phenanthrolin-7-yl group, 1, 9-phenanthrolin-8-yl group, 1,9-phenanthrolin-10-yl group, 1,10-phenanthrolin-2-yl group, 1,10-phenanthrolin-3-yl group, 1,10-phenanthrolin-4-yl group, 1,10-phenanthrolin-5-yl group, 2,9-phenanthrolin-1-yl group, 2,9-phenanthrolin-3-yl group, 2,9-phenanthrolin-4-yl group, 2,9-phenanthrolin-5-yl group, 2,9-phenanthrolin-6-yl group, 2,9-phenanthrolin-7-yl group, 2,9-phenanthrolin-8-yl group, 2,9-phenanthrolin-10-yl group, 2,8-phenanthrolin-1-yl group, 2,8-phenanthrolin-3-yl group, 2,8-phenanthrolin-4-yl group, 2,8-phenanthrolin-5-yl group, 2,8-phenanthrolin-6-yl group, 2,8-phenanthrolin-7-yl group, 2,8-phenanthrolin-9-yl group, 2,8-phenanthrolin-10-yl group, 2,7-phenanthrolin-1-yl group, 2,7-phenanthrolin-3-yl group, 2,7-phenanthrolin-4-yl group, 2,7-phenanthrolin-5-yl group, 2,7-phenanthrolin-6-yl group, 2,7-phenanthrolin-8-yl group, 2,7-phenanthrolin-9-yl group, 2,7-phenanthrolin-10-yl group, 1-phenazinyl group, 2-phenazinyl group, 1-phenothiadinyl group, 2-phenothiadinyl group, 3-phenothiadinyl group, 4-phenothiadinyl group, 10-phenothiadinyl group, 1-phenoxadinyl group, 2-phenoxadinyl group, 3-phenoxadinyl group, 4-phenoxadinyl group, 10-phenoxadinyl group, 2-oxazolyl group, 4-oxazolyl group, 5-oxazolyl group, 2-oxadiazolyl group, 5-oxadiazolyl group, 3-furazanyl group, 2-thienyl group, 3-thienyl group, 2-methylpyrrol-1-yl group, 2-methylpyrrol-3-yl group, 2-methylpyrrol-4-yl group, 2-methylpyrrol-5-yl group, 3-methylpyrrol-1-yl group, 3-methylpyrrol-2-yl group, 3-methylpyrrol-4-yl group, 3-methylpyrrol-5-yl group, 2-t-butyl-pyrrol-4-yl group, 3-(2-phenylpropyl)pyrrol-1-yl group, 2-methyl-1-indolyl group, 4-methyl-1-indolyl group, 2-methyl-3-indolyl group, 4-methyl-3-indolyl group, 2-t-butyl-1-indolyl group, 4-t-butyl-1-indolyl group, 2-t-butyl-3-indolyl group, 4-t-butyl-3-indolyl group, and the like can be given.

As examples of the substituted or unsubstituted alkyl group, a methyl group, ethyl group, propyl group, isopropyl group, n-butyl group, s-butyl group, isobutyl group, t-butyl group, n-pentyl group, n-hexyl group, n-heptyl group, n-octyl group, hydroxymethyl group, 1-hydroxyethyl group, 2-hydroxyethyl group, 2-hydroxyisobutyl group, 1,2-dihydroxyethyl group, 1,3-dihydroxyisopropyl group, 2,3-dihydroxy-t-butyl group, 1,2,3-trihydroxypropyl group, chloromethyl group, 1-chloroethyl group, 2-chloroethyl group, 2-chloroisobutyl group, 1,2-dichloroethyl group, 1,3-dichloroisopropyl group, 2,3-dichloro-t-butyl group, 1,2,3-trichloropropyl group, bromomethyl group, 1-bromoethyl group, 2-bromoethyl group, 2-bromoisobutyl group, 1,2-dibromoethyl group, 1,3-dibromoisopropyl group, 2,3-dibromo-t-butyl group, 1,2,3-tribromopropyl group, iodomethyl group, 1-iodoethyl group, 2-iodoethyl group, 2-iodoisobutyl group, 1,2-diiodoethyl group, 1,3-diiodoisopropyl group, 2,3-diiodo-t-butyl group, 1,2,3-triiodopropyl group, aminomethyl group, 1-aminoethyl group, 2-aminoethyl group, 2-aminoisobutyl group, 1,2-diaminoethyl group, 1,3-diaminoisopropyl group, 2,3-diamino-t-butyl group, 1,2,3-triaminopropyl group, cyanomethyl group, 1-cyanoethyl group, 2-cyanoethyl group, 2-cyanoisobutyl group, 1,2-dicyanoethyl group, 1,3-dicyanoisopropyl group, 2,3-dicyano-t-butyl group, 1,2,3-tricyanopropyl group, nitromethyl group, 1-nitroethyl group, 2-nitroethyl group, 2-nitroisobutyl group, 1,2-dinitroethyl group, 1,3-dinitroisopropyl group, 2,3-dinitro-t-butyl group, 1,2,3-trinitropropyl group, cyclopropyl group, cyclobutyl group, cyclopentyl group, cyclohexyl group, 4-methylcyclohexyl group, 1-adamantyl group, 2-adamantyl group, 1-norbornyl group, 2-norbornyl group, and the like can be given.

Specific examples of the fluoranthene derivative are given below.

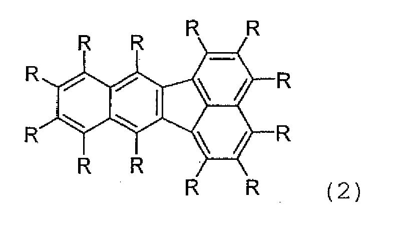

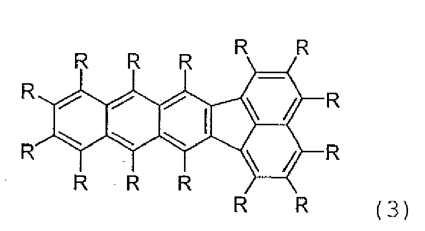

R of the formulas (2) and (3) is the same as R of the formula (1).

R is preferably a hydrogen or phenyl group. It is more preferable that in the formulas (2) and (3), opposing two Rs substituted for a naphthalene skeleton or anthracene skeleton be a phenyl group, and the other be a hydrogen atom.

Specific examples of the indenoperylene derivative are given below.

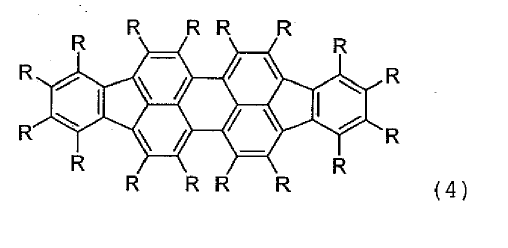

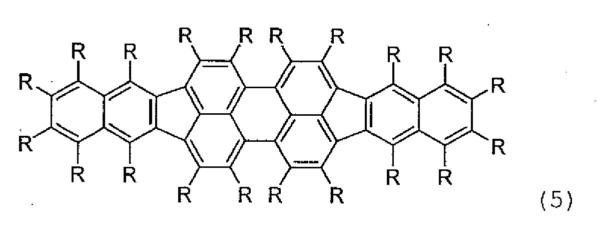

R of the formulas (4) and (5) is the same as R of the formula (1).

The use of a fluoranthene derivative as a host material and an indenoperylene derivative as a dopant material in an organic EL device realizes an organic EL device with a practical efficiency and lifetime.

Specifically, in an organic EL device comprising at least the emitting layer and an electron-transporting layer provided between a cathode and an anode, an emitting layer contains a host material which is the fluoranthene derivative and a dopant material which is the indenoperylene derivative.
For example, FIG. 1 shows an example of the organic EL device according to the invention. An organic EL device 1 has a configuration in which an anode 20, a hole injecting layer 30, a hole transporting layer 40, an emitting layer 50, an electron transporting layer 60, an electron injecting layer 70, and a cathode 80 are stacked on a substrate 10 in that order. The emitting layer 50 contains a host material which is the fluoranthene derivative and a dopant material which is the indenoperylene derivative.

As examples of the indenoperylene derivative used for a dopant material, a dibenzo tetraphenyl perifuranthene derivative is preferable.

The doping concentration of the dopant material contained in the emitting layer is preferably 0.1 to 10 wt%, and more preferably 0.5 to 2 wt%.

The electron-transporting layer preferably contains a compound represented by the following general formula (6):

(A)ᵤ-(B)ᵥ (6)

wherein A is an aromatic hydrocarbon group with 3 or more carbon circles and B is a heterocyclic group which may be substituted. u and v are each an integer of 1 to 6.

The aromatic hydrocarbon group with 3 or more carbocircles of the group A includes anthracene, phenanthrene, naphthacene, pyrene, chrysene, benzanthracene, pentacene, dibenzoanthracene, benzopyrene, fluorene, benzofluorene, fluoranthene, benzofluoranthene, naphthofluoranthene, dibenzofluorene, dibenzopyrene and dibenzofluoranthene.

The substituted or unsubstituted heterocyclic group of the group B includes pyridine, pyrimidine, pyrazine, pyridazine, triazine, quinoline, quinoxaline, acridine, imidazopyridine, imidazopyrimidine and phenenthroline.

The compound represented by formula (6) is preferably a compound containing in the molecule thereof at least one skeleton selected from anthracene, phenanthrene, naphthacene, pyrene, chrysene, benzoanthracene, pentacene, dibenzoanthracene, benzopyrene, fluorene, benzofluorene, fluoranthene, benzofluoranthene, naphthofluoranthene, dibenzofluorene, dibenzopyrene and dibenzofluoranthene.

The compound represented by the formula (6) is preferably a nitrogen-containing heterocyclic compound.
The nitrogen-containing heterocyclic compound preferably contains in the molecule thereof at least one skeleton selected from pyridine, pyrimidine, pyrazine, pyridazine, triazine, quinoline, quinoxaline, acridine, imidazopyridine, imidazopyrimidine and phenenthroline.

The nitrogen-containing heterocyclic compound is more preferably a benzoimidazole derivative represented by the following general formula (7) or (8).

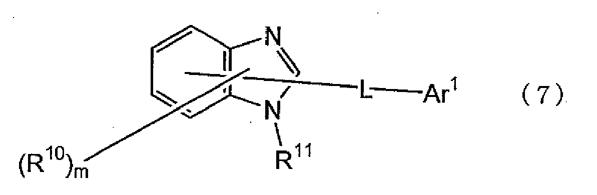

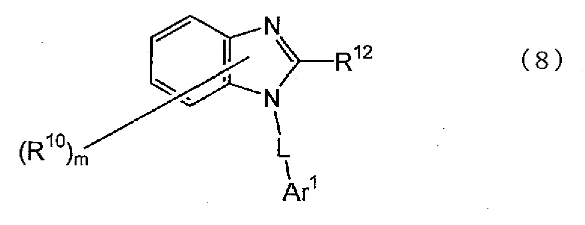

wherein R¹⁰ is a hydrogen atom, a substituted or unsubstituted aryl group having 6 to 60 carbon atoms, a substituted or unsubstituted pyridyl group, a substituted or unsubstituted quinolyl group, a substituted or unsubstituted alkyl group having 1 to 50 carbon atoms or a substituted or unsubstituted alkoxy group having 1 to 50 carbon atoms.

As examples of the substituted or unsubstituted aryl group having 6 to 60 carbon atoms, preferred are a phenyl group, 1-naphthyl group, 2-naphthyl group, 1-anthryl group, 2-anthryl group, 9-anthryl group, 1-phenanthryl group, 2-phenanthryl group, 3-phenanthryl group, 4-phenanthryl group, 9-phenanthryl group, 1-naphthacenyl group, 2-naphthacenyl group, 9-naphthacenyl group, 1-pyrenyl group, 2-pyrenyl group, 4-pyrenyl group, 2-biphenylyl group, 3-biphenylyl group, 4-biphenylyl group, p-terphenyl-4-yl group, p-terphenyl-3-yl group, p-terphenyl-2-yl group, m-terphenyl-4-yl group, m-terphenyl-3-yl group, m-terphenyl-2-yl group, o-tolyl group, m-tolyl group, p-tolyl group, p-t-butylphenyl group, p-(2-phenylpropyl)phenyl group, 3-methyl-2-naphthyl group, 4-methyl-1-naphthyl group, 4-methyl-1-anthryl group, 4'-methylbiphenylyl group, 4"-t-butyl-p-terphenyl-4-yl group, fluoranthenyl group, fluorenyl group and the like. More preferred are a phenyl group, naphthyl group, biphenyl group, anthracenyl group, phenanthryl group, pyrenyl group, crycenyl group, fluoranthenyl group and fluorenyl group and the like.

As examples of the substituted or unsubstituted alkyl group having 1 to 50 carbon atoms, a methyl group, ethyl group, propyl group, isopropyl group, n-butyl group, s-butyl group, isobutyl group, t-butyl group, n-pentyl group, n-hexyl group, n-heptyl group, n-octyl group, hydroxymethyl group, 1-hydroxyethyl group, 2-hydroxyethyl group, 2-hydroxyisobutyl group, 1,2-dihydroxyethyl group, 1,3-dihydroxyisopropyl group, 2,3-dihydroxy-t-butyl group, 1,2,3-trihydroxypropyl group, chloromethyl group, 1-chloroethyl group, 2-chloroethyl group, 2-chloroisobutyl group, 1,2-dichloroethyl group, 1,3-dichloroisopropyl group, 2,3-dichloro-t-butyl group, 1,2,3-trichloropropyl group, bromomethyl group, 1-bromoethyl group, 2-bromoethyl group, 2-bromoisobutyl group, 1,2-dibromoethyl group, 1,3-dibromoisopropyl group, 2,3-dibromo-t-butyl group, 1,2,3-tribromopropyl group, iodomethyl group, 1-iodoethyl group, 2-iodoethyl group, 2-iodoisobutyl group, 1,2-diiodoethyl group, 1,3-diiodoisopropyl group, 2,3-diiodo-t-butyl group, 1,2,3-triiodopropyl group, aminomethyl group, 1-aminoethyl group, 2-aminoethyl group, 2-aminoisobutyl group, 1,2-diaminoethyl group, 1,3-diaminoisopropyl group, 2,3-diamino-t-butyl group, 1,2,3-triaminopropyl group, cyanomethyl group, 1-cyanoethyl group, 2-cyanoethyl group, 2-cyanoisobutyl group, 1,2-dicyanoethyl group, 1,3-dicyanoisopropyl group, 2,3-dicyano-t-butyl group, 1,2,3-tricyanopropyl group, nitromethyl group, 1-nitroethyl group, 2-nitroethyl group, 2-nitroisobutyl group, 1,2-dinitroethyl group, 1,3-dinitroisopropyl group, 2,3-dinitro-t-butyl group, 1,2,3-trinitropropyl group, cyclopropyl group, cyclobutyl group, cyclopentyl group, cyclohexyl group, 4-methylcyclohexyl group, 1-adamantyl group, 2-adamantyl group, 1-norbornyl group, 2-norbornyl group, and the like can be given.

The substituted or unsubstituted alkoxy group having 1 to 50 carbon atoms is a group shown by -OY. Examples of Y include the above examples for the alkyl group.

As a substituent of the above aryl group, pyridinyl group, quinolinyl group, alkyl group or alkoxy group, a substituted or unsubstituted aryl group having 6 to 50 ring carbon atoms, a substituted or unsubstituted aromatic heterocyclic group having 5 to 50 ring atoms, a substituted or unsubstituted alkyl group having 1 to 50 carbon atoms, a substituted or unsubstituted alkoxy group having 1 to 50 carbon atoms, a substituted or unsubstituted aralkyl group having 1 to 50 carbon atoms, a substituted or unsubstituted aryloxy group having 5 to 50 ring atoms, a substituted or unsubstituted arylthio group having 5 to 50 ring atoms, a substituted or unsubstituted carboxyl group having 1 to 50 carbon atoms, a halogen group, a cyano group, a nitro group, a hydroxy group, or the like are given.

m is an integer from 0 to 4, preferably from 0 to 3 and more preferably from 0 to 2.

R¹¹ is a substituted or unsubstituted aryl group having 6 to 60 carbon atoms, substituted or unsubstituted pyridyl group, substituted or unsubstituted quinolyl group, substituted or unsubstituted alkyl group having 1 to 20 carbon atoms or alkoxy group having 1 to 20 carbon atoms. Examples of the groups and substituents of R¹¹ are the same as those of the above-mentioned R¹⁰.

R¹² is a hydrogen atom, substituted or unsubstituted aryl group having 6 to 60 carbon atoms, substituted or unsubstituted pyridyl group, substituted or unsubstituted quinolyl group, substituted or unsubstituted alkyl group having 1 to 20 carbon atoms, or substituted or unsubstituted alkoxy group having 1 to 20 carbon atoms. Examples of the groups and substituents of R¹² are the same as those of the above-mentioned R¹⁰.

L is a substituted or unsubstituted arylene group having 6 to 60 carbon atoms, substituted or unsubstituted pyridinylene group, substituted or unsubstituted quinoliylene group, or substituted or unsubstituted fluorenylene group.

The arylene group having 6 to 60 carbon atoms is preferably a divalent substituent obtainable by removing one hydrogen atom from the substituent described for the aryl group having 6 to 60 carbon atoms, more preferably a phenylene group, naphthylene group, biphenylene group, anthracenylene group, phenanthrylene group, pyrenylene group, chrysenylene group, fluoranthenylene group or fluorenylene group.

Examples of substituents of the arylene group, pyridinylene group, quinoliylene group or fluorenylene group are the same as those of the above-mentioned R¹⁰.

Ar¹ is a substituted or unsubstituted aryl group having 6 to 60 carbon atoms (preferably 6 to 30 carbon atoms), a substituted or unsubstituted pyridinyl group or a substituted or unsubstituted quinolinyl group.
Substituents of the aryl group having 6 to 60 carbon atoms, pyridinyl group and quinolinyl group are the same as those of the above-menioned R¹⁰.

For the benzoimidazole derivatives represented by formulas (7), m is preferably 0, R¹¹ is preferably an aryl group, L is preferably an arylane group with 6 to 30 carbon atoms (more preferably 6 to 20 carbon atoms) and Ar¹ is preferably an aryl group with 6 to 30 carbon atoms.

For the benzoimidazole derivatives represented by formulas (8), m is preferably 0, R¹² is preferably an aryl group, L is preferably an arylane group with 6 to 30 carbon atoms (more preferably 6 to 20 carbon atoms) and Ar¹ is preferably an aryl group with 6 to 30 carbon atoms.

The organic EL device of the invention preferably emit orange to red light.

### [Structure of organic EL device]

The typical examples of the structure of the organic EL device of the invention are shown below. The invention is not limited to these.
(1) Anode/emitting layer/electron-transporting layer /cathode
(2) Anode/hole-transporting layer/emitting layer/electron-transporting layer/cathode
(3) Anode/hole-injecting layer/hole-transporting layer/emitting layer/electron-transporting layer/cathode
(4) Anode/hole-transporting layer/emitting layer/electron-transporting layer/electron-injecting layer/cathode
(5) Anode/hole-injecting layer/hole-transporting layer/emitting layer/electron-transporting layer/electron-injecting layer/cathode
(6) Anode/insulating layer/hole-transporting layer/emitting layer/electron-transporting layer/cathode
(7) Anode/hole-transporting layer/emitting layer/electron-transporting layer/insulating layer/cathode
(8) Anode/insulating layer/hole-transporting layer/emitting layer/electron-transporting layer/insulating layer/cathode
(9) Anode/hole-injecting layer/hole-transporting layer/emitting layer/electron-transporting layer/insulating layer/cathode
(10) Anode/insulating layer/hole-injecting layer/hole-transporting layer/emitting layer/electron-transporting layer/electron-injecting layer/cathode
(11) Anode/insulating layer/hole-injecting layer/hole-transporting layer/emitting layer/electron-transporting layer/electron-injecting layer/insulating layer/cathode
   Among these, the structures (2), (3), (4), (5), (8), (9) and (11) are generally preferably used.

Functions of individual layers of an organic EL device are described below.

### [Transparent substrate]

If an organic EL device is of under surface emission type or bottom emission type where light is outcoupled through a substrate, the organic EL device of the invention is formed on transparent substrate. The transparent substrate is a substrate for supporting the organic EL device, and is preferably a flat and smooth substrate having a transmittance of 50% or more to light rays within visible ranges of 400 to 700 nm.
Specific examples thereof include glass plates and polymer plates. Examples of the glass plate include soda-lime glass, barium/strontium-containing glass, lead glass, aluminosilicate glass, borosilicate glass, barium borosilicate glass, and quartz. Examples of the polymer plate include polycarbonate, acrylic polymer, polyethylene terephthalate, polyethersulfide, and polysulfone. A TFT substrate where TFT is formed for drive may be used.

If an organic EL device is of upper surface emission type or top emission type where light is outcoupled from the upper part of the device, a light-reflecting metal such as aluminum is provided on the above substrate.

### [Anode]

The anode of the organic EL device of the invention plays a role for injecting holes into its hole-transporting layer or emitting layer. The anode effectively has a work function of 4.5 eV or more. Specific examples of the material of the anode used in the invention include indium tin oxide alloy (ITO), zinc tin oxide alloy (IZO), tin oxide (NESA), gold, silver, platinum, and copper.
Although these materials may be used individually, alloys thereof or materials wherein another element is added to the materials can be selected for use.
The anode can be formed by forming these electrode materials into a thin film by vapor deposition, sputtering or the like.

In an organic EL device of under sueface emission or bottom emission type, an anode preferably has a transmittance of 10 % or more to emitted light. The sheet resistance of the anode is preferably several hundreds Ω/□ or less. The film thickness of the anode, which varies depending upon the material thereof, is usually from 10 nm to 1 µm, preferably from 10 to 200 nm.

### [Emitting layer]

The emitting layer of the organic EL device has the following functions in combination. Namely,
(i) Injecting function: function of allowing injection of holes from anode or hole injecting/transporting layer and injection of electrons from cathode or electron injecting/transporting layer upon application of electric field
(ii) Transporting function: function of moving injected carriers (electrons and holes) due to force of electric field
(iii) Emitting function: function of providing a site for recombination of electrons and holes to emit light
   Note that electrons and holes may be injected into the emitting layer with different degrees, or the transportation capabilities indicated by the mobilities of holes and electrons may differ. It is preferable that the emitting layer move either electrons or holes.

As the method of forming the emitting layer, a known method such as deposition, spin coating, or an LB method may be applied. It is preferable that the emitting layer be a molecular deposition film.
The term "molecular deposition film" refers to a thin film formed by depositing a vapor-phase material compound or a film formed by solidifying a solution-state or liquid-phase material compound. The molecular deposition film is distinguished from a thin film (molecular accumulation film) formed using the LB method by the difference in aggregation structure or higher order structure or the difference in function due to the difference in structure.
The emitting layer may also be formed by dissolving a binder such as a resin and a material compound in a solvent to obtain a solution, and forming a thin film from the solution by spin coating or the like, as disclosed in JP-A-57-51781.

### [Hole-transporting and hole-injecting layer]

The hole-transporting layer is a layer for helping the injection of holes into the emitting layer so as to transport holes to an emitting region. The hole mobility thereof is large and the ionization energy thereof is usually as small as 5.5 eV or less. Such a hole-transporting layer is preferably made of a material which can transport holes to the emitting layer at a low electric field intensity. The hole mobility thereof is preferably at least 10⁻⁴ cm²/V·second when an electric field of, e.g., 10⁴ to 10⁶ V/cm is applied.
Any materials which have the above preferable properties can be used as the material for forming the hole-transporting layer without particular limitation. The material for forming the hole-transporting layer can be arbitrarily selected from materials which have been widely used as a material transporting carriers of holes in photoconductive materials and known materials used in a hole-transporting layer of EL devices.

Specific examples include triazole derivatives (see USP No. 3, 112, 197 and others), oxadiazole derivatives (see USP No. 3,189,447 and others), imidazole derivatives (see JP-B-37-16096 and others), polyarylalkane derivatives (see USP Nos. 3,615,402, 3,820,989 and 3,542,544, JP-B-45-555 and 51-10983, JP-A-51-93224, 55-17105, 56-4148, 55-108667, 55-156953 and 56-36656, and others), pyrazoline derivatives and pyrazolone derivatives (see USP Nos. 3, 180, 729 and 4,278,746, JP-A-55-88064, 55-88065, 49-105537, 55-51086, 56-80051, 56-88141, 57-45545, 54-112637 and 55-74546, and others), phenylene diamine derivatives (see USP No. 3,615,404, JP-B-51-10105, 46-3712 and 47-25336, JP-A-54-53435, 54-110536 and 54-119925, and others), arylamine derivatives (see USP Nos. 3,567,450, 3,180,703, 3,240,597, 3,658,520, 4,232,103, 4,175,961 and 4,012,376, JP-B-49-35702 and 39-27577, JP-A-55-144250, 56-119132 and 56-22437, DE1,110,518, and others), amino-substituted chalcone derivatives (see USP No. 3,526,501, and others), oxazole derivatives (ones disclosed in USP No. 3,257,203, and others), styrylanthracene derivatives (see JP-A-56-46234, and others), fluorenone derivatives (JP-A-54-110837, and others), hydrazone derivatives (see USP Nos. 3,717,462, JP-A-54-59143, 55-52063, 55-52064, 55-46760, 55-85495, 57-11350, 57-148749 and 2-311591, and others), stilbene derivatives (see JP-A-61-210363, 61-228451, 61-14642, 61-72255, 62-47646, 62-36674, 62-10652, 62-30255, 60-93455, 60-94462, 60-174749 and 60-175052, and others), silazane derivatives (USP No. 4,950,950), polysilanes (JP-A-2-204996), aniline copolymers (JP-A-2-282263), and electroconductive high molecular oligomers (in particular thiophene oligomers) disclosed in JP-A-1-211399.

The material shown in the formula below is preferable used.

Q¹-G-Q²

wherein Q¹ and Q² are parts having at least one tertiary amine and G is a linkage group.

More preferably, an amine derivative shown by the formula below is used. 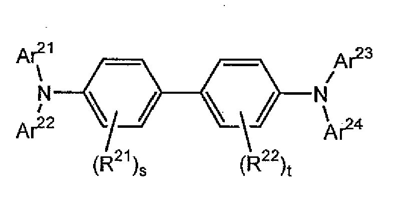 wherein Ar²¹ to Ar²⁴ are a substituted or unsubstituted aromatic ring having 6 to 50 ring carbon atoms, or substituted or unsubstituted aromatic heterocycle having 5 to 50 ring atoms.
R²¹ and R²² are substituents and s and t are integers from 0 to 4, respectively.
Ar²¹ and Ar²², and Ar²³ and Ar²⁴ may be bonded together to form a ring, respectively.
R²¹ and R²² may also be bonded together to form a ring.
Substituents of Ar²¹ to Ar²⁴, R²¹ and R²² are a substituted or unsubstituted aromatic ring having 6 to 50 ring carbon atoms, substituted or unsubstituted aromatic heterocycle having 5 to 50 ring atoms, alkyl group having 1 to 50 carbon atoms, alkoxy group having 1 to 50 carbon atoms, alkylaryl group having 1 to 50 carbon atoms, aralkyl group having 1 to 50 carbon atoms, styryl group, amino group substituted with an aromatic ring having 6 to 50 ring carbon atoms or a hetero aromatic ring having 5 to 50 ring atoms, or aromatic ring having 6 to 50 ring carbon atoms or hetero aromatic ring having 5 to 50 ring atoms, the aromatic ring and the hetero aromatic ring being substituted with an amino group substituted with an aromatic ring having 6 to 50 ring carbon atoms or a hetero aromatic ring having 5 to 50 ring atoms.

Further, a hole-injecting layer can be provided in addition to the hole-transporting layer so as to help the injection of holes. The same substances used for the hole-transporting layer can be used as the material of the hole-injecting layer. The following can also be used: porphyrin compounds (disclosed in JP-A-63-2956965 and others), aromatic tertiary amine compounds and styrylamine compounds (see USP No. 4,127,412, JP-A-53-27033, 54-58445, 54-149634, 54-64299, 55-79450, 55-144250, 56-119132, 61-295558, 61-98353 and 63-295695, and others). Aromatic tertiary amine compounds are particularly preferably used.

The following can also be given as examples: 4,4'-bis(N-(1-naphthyl)-N-phenylamino)biphenyl (abbreviated as NPD hereinafter), which has in the molecule thereof two condensed aromatic rings, disclosed in USP No. 5,061,569, and 4,4',4"-tris(N-(3-methylphenyl)-N-phenylamino)triphenylamin e (abbreviated as MTDATA, hereinafter), wherein three triphenylamine units are linked to each other in a star-burst form, disclosed in JP-A-4-308688.

In addition, nitrogen-containing heterocyclic derivatives represented by the following formula disclosed in JP-B-03571977 can also be used.

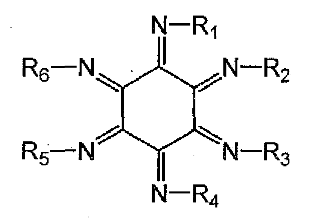

wherein R₁ to R₆ are a substituted or unsubstituted alkyl group, substituted or unsubstiuted aryl group, a substituted or unsubstiuted aralkyl group, or a substituted or unsubstiuted heterocyclic group; provided that R₁ to R₆ may be the same as each other or may be different from each other; and R₁ and R₂, R₃ and R₄, and R₅ and R₆, or R₁ and R₆, R₂ and R₃, and R₄ and R₅ may be bonded together to form a condensed ring.

Furthermore, compounds represented by the following formula disclosed in US-A1-2004-113547 can also be used.

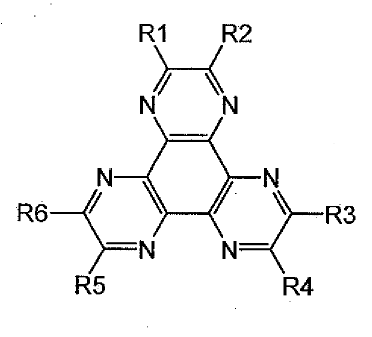

wherein R1 to R6 are a substituent, and preferably an electron-withdrawing group such as a cyano group, nitro group, sulfonyl group, carbonyl group, trifluoromethyl group and halogen.

Inorganic compounds such as p-type Si and p-type SiC as well as aromatic dimethylidene type compounds can also be used as the material of the hole-injecting layer.

The hole-injection layer or the hole-transporting layer can be formed by forming the above-mentioned compounds into a thin film by a known method such as vacuum deposition, spin coating, casting or LB technique. The film thickness of the hole-injecting/transporting layer is not particularly limited, and is usually from 5 nm to 5 µm. This hole-injecting layer or the hole-transporting layer may be a single layer made of one or more of the above-mentioned materials, or may be stacked hole-injecting layers or hole-transporting layers made of different compounds, insofar as the compound of the invention is contained in a hole-transporting region.

The organic semiconductor layer is one kind of a hole transporting layer for helping the injection of holes or electrons into the emitting layer, and is preferably a layer having an electric conductivity of 10⁻¹⁰ S/cm or more. As the material of such an organic semiconductor layer, electroconductive oligomers such as thiophene-containing oligomers or arylamine-containing oligomers disclosed in JP-A-8-193191, and electroconductive dendrimers such as arylamine-containing dendrimers may be used.

### [Electron-transporting layer]

The above compounds of formulas (6), (7) and (8) are preferable for an electron-transporting layer. In addition, the following may also be used.
The electron transporting layer is a layer which assists injection of electrons into the luminescent medium layer, and exhibits a high electron mobility. The thickness of the electron transporting layer is arbitrarily selected in the range of several nanometers to several micrometers. When the electron transporting layer has a large thickness, it is preferable that the electron mobility be at least 10⁻⁵ cm²/Vs or more at an applied electric field of 10⁴ to 10⁶ V/cm in order to prevent an increase in voltage.
As the material used for the electron transporting layer, 8-hydroxyquinoline, a metal complex of an 8-hydroxyquinoline derivative, and a compound having a nitrogen-containing heterocyclic ring are suitable.

As specific examples of 8-hydroxyquinoline and a metal complex of an 8-hydroxyquinoline derivative, metal chelate oxinoid compounds including a chelate of oxine (ordinarily 8-quinolinol or 8-hydroxyquinoline) can be given. For example, Alq having Al as the center metal may be used for the electron transporting layer.
An electron transporting compound of the following general formula can be given as the oxadiazole derivative.

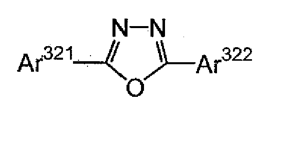

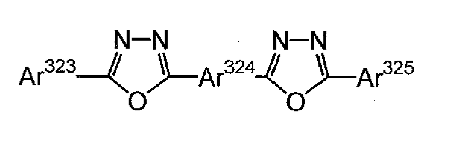

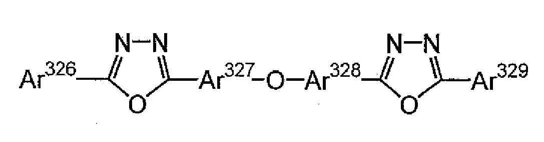

wherein Ar³²¹, Ar³²², Ar³²³, Ar³²⁵, Ar³²⁶, and Ar³²⁹ are independently substituted or unsubstituted aryl groups and may be the same or different. Ar³²⁴, Ar³²⁷, and Ar³²⁸ are independently substituted or unsubstituted arylene groups and may be the same or different.

As examples of the aryl group, a phenyl group, a biphenyl group, an anthranyl group, a perylenyl group, and a pyrenyl group can be given. As examples of the arylene group, a phenylene group, a naphthylene group, a biphenylene group, an anthranylene group, a perylenylene group, a pyrenylene group, and the like can be given. As the substituent, an alkyl group having 1 to 10 carbon atoms, an alkoxy group having 1 to 10 carbon atoms, a cyano group, and the like can be given. The electron transporting compound is preferably one from which a thin film can be formed.
The following compounds can be given as specific examples of the electron transporting compound.

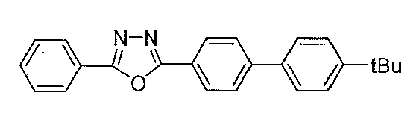

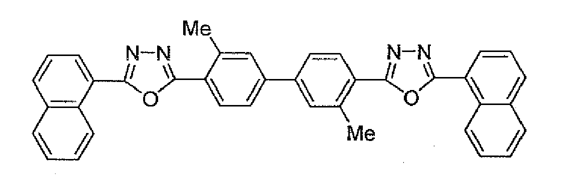

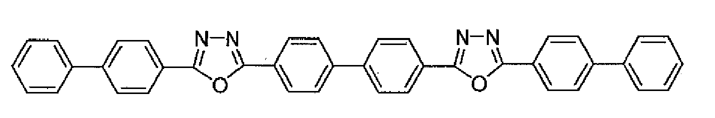

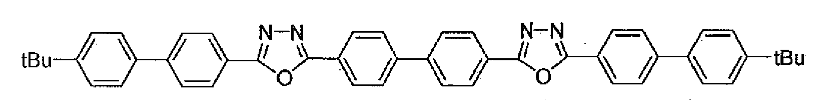

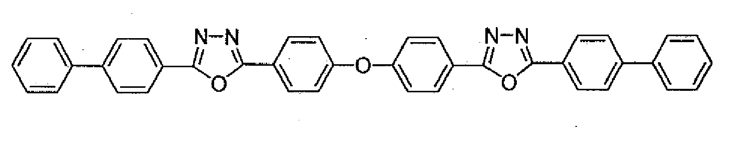

wherein Me is a methyl group, and Bu is a butyl group.

Nitrogen-containing heterocyclic ring derivatives of the following formulas 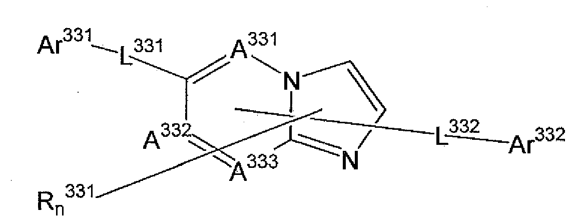 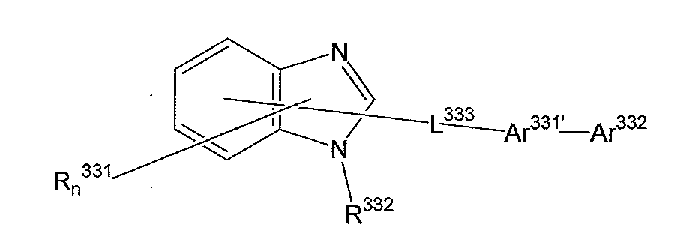 wherein A³³¹ to A³³³ are a nitrogen atom or a carbon atom;
R³³¹ and R³³² are a substituted or unsubstituted aryl group having 6 to 60 carbon atoms, a substituted or unsubstituted heteroaryl group having 3 to 60 carbon atoms, an alkyl group having 1 to 20 carbon atoms, a haloalkyl group having 1 to 20 carbon atoms, or an alkoxy group having 1 to 20 carbon atoms, and n is an integer of 0 to 5, provided that, when n is an integer of 2 or more, R³³¹s may be the same or different;
adjacent R³³¹s may be bonded to form a substituted or unsubstituted carbocyclic aliphatic ring or a substituted or unsubstituted carbocyclic aromatic ring;
Ar³³¹ is a substituted or unsubstituted aryl group having 6 to 60 carbon atoms or a substituted or unsubstituted heteroaryl group having 3 to 60 carbon atoms;
Ar^{331'} is a substituted or unsubstituted arylene group having 6 to 60 carbon atoms or a substituted or unsubstituted heteroarylene group having 3 to 60 carbon atoms;
Ar³³² is a hydrogen atom, an alkyl group having 1 to 20 carbon atoms, a haloalkyl group having 1 to 20 carbon atoms, an alkoxy group having 1 to 20 carbon atoms, a substituted or unsubstituted aryl group having 6 to 60 carbon atoms, or a substituted or unsubstituted heteroaryl group having 3 to 60 carbon atoms;
provided that one of Ar³³¹ and Ar³³² is a substituted or unsubstituted condensed ring group having 10 to 60 carbon atoms or a substituted or unsubstituted heterocondensed ring group having 3 to 60 carbon atoms;
L³³¹, L³³², and L³³³ are independently a single bond, a substituted or unsubstituted condensed ring having 6 to 60 carbon atoms, a substituted or unsubstituted heterocondensed ring having 3 to 60 carbon atoms, or a substituted or unsubstituted fluorenylene group.

Nitrogen-containing heterocyclic ring derivatives of the following formula disclosed in Japanese Patent Application No. 2003-004193

HAr-L³⁴¹-Ar³⁴¹-Ar³⁴²

wherein HAr is a substituted or unsubstituted nitrogen-containing heterocyclic ring having 3 to 40 carbon atoms,
L³⁴¹ is a single bond, a substituted or unsubstituted arylene group having 6 to 60 carbon atoms, a substituted or unsubstituted heteroarylene group having 3 to 60 carbon atoms, or a substituted or unsubstituted fluorenylene group,;
Ar³⁴¹ is a divalent substituted or unsubstituted aromatic hydrocarbon group having 6 to 60 carbon atoms, and
Ar³⁴² is a substituted or unsubstituted aryl group having 6 to 60 carbon atoms or a substituted or unsubstituted heteroaryl group having 3 to 60 carbon atoms.

Silacyclopentadiene derivatives of the following formula disclosed in JP-A-09-087616 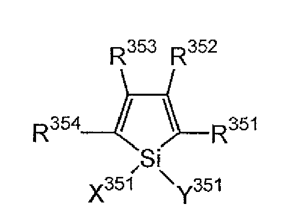 wherein X³⁵¹ and Y³⁵¹ are independently a saturated or unsaturated hydrocarbon group having 1 to 6 carbon atoms, an alkoxy group, an alkenyloxy group, an alkynyloxy group, a hydroxyl group, a substituted or unsubstituted aryl group, or a substituted or unsubstituted hetero ring, or X³⁵¹ and Y³⁵¹ are bonded to form a saturated or unsaturated ring, and R³⁵¹ to R³⁵⁴ are independently hydrogen, halogen, a substituted or unsubstituted aryl group having 1 to 6 carbon atoms, an alkoxy group, an aryloxy group, a perfluoroalkyl group, a perfluoroalkoxy group, an amino group, an alkylcarbonyl group, an arylcarbonyl group, an alkoxycarbonyl group, an aryloxycarbonyl group, an azo group, an alkylcarbonyloxy group, an arylcarbonyloxy group, an alkoxycarbonyloxy group, an aryloxycarbonyloxy group, a sulfinyl group, a sulfonyl group, a sulfanyl group, a silyl group, a carbamoyl group, an aryl group, a heterocyclic group, an alkenyl group, an alkynyl group, a nitro group, a formyl group, a nitroso group, a formyloxy group, an isocyano group, a cyanate group, an isocyanate group, a thiocyanate group, an isothiocyanate group, or a cyano group, or adjacent groups of R³⁵¹ to R³⁵⁴ form a substituted or unsubstituted condensed ring.

Silacyclopentadiene derivatives of the following formula disclosed in JP-A-09-194487 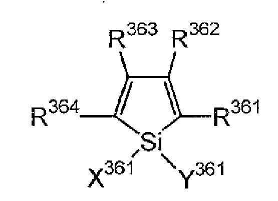 wherein X³⁶¹ and Y³⁶¹ are independently a saturated or unsaturated hydrocarbon group having 1 to 6 carbon atoms, alkoxy group, alkenyloxy group, alkynyloxy group, substituted or unsubstituted aryl group, or substituted or unsubstituted hetero ring, or X³⁶¹ and Y³⁶¹ are bonded to form a saturated or unsaturated ring, and R³⁶¹ to R³⁶⁴ are independently hydrogen, halogen, a substituted or unsubstituted alkyl group having 1 to 6 carbon atoms, alkoxy group, aryloxy group, perfluoroalkyl group, perfluoroalkoxy group, amino group, alkylcarbonyl group, arylcarbonyl group, alkoxycarbonyl group, aryloxycarbonyl group, azo group, alkylcarbonyloxy group, arylcarbonyloxy group, alkoxycarbonyloxy group, aryloxycarbonyloxy group, sulfinyl group, sulfonyl group, sulfanyl group, silyl group, carbamoyl group, aryl group, heterocyclic group, alkenyl group, alkynyl group, nitro group, formyl group, nitroso group, formyloxy group, isocyano group, cyanate group, isocyanate group, thiocyanate group, isothiocyanate group, or cyano group, or adjacent groups of R³⁶¹ to R³⁶⁴ form a substituted or unsubstituted condensed ring, (provided that, when R³⁶¹ and R³⁶⁴ are phenyl groups, X³⁶¹ and Y³⁶¹ are neither an alkyl group nor a phenyl group, when R³⁶¹ and R³⁶⁴ are thienyl groups, the case is excluded in which X³⁶¹ and Y³⁶¹ are a monovalent hydrocarbon group and R³⁶² and R³⁶³ are an alkyl group, an aryl group, an alkenyl group, or R³⁶² and R³⁶³ are aliphatic groups which form a ring by bonding to each other, when R³⁶¹ and R³⁶⁴ are silyl groups, R³⁶², R³⁶³, X³⁶¹, and Y³⁶¹ are neither independently a monovalent hydrocarbon group having 1 to 6 carbon atoms nor a hydrogen atom, and when a benzene ring is condensed at the positions of R³⁶¹ and R³⁶², X³⁶¹ and Y³⁶¹ are neither an alkyl group nor a phenyl group).

Borane derivatives of the following formula disclosed in JP-T-2000-040586 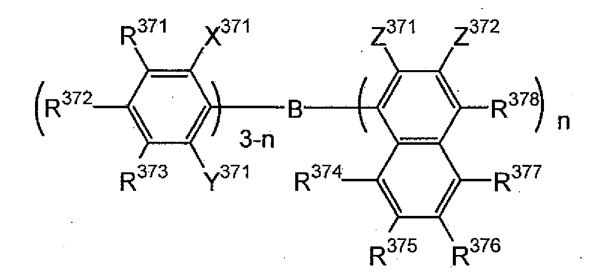 wherein R³⁷¹ to R³⁷⁸ and Z³⁷² are independently a hydrogen atom, a saturated or unsaturated hydrocarbon group, an aromatic group, a heterocyclic group, a substituted amino group, a substituted boryl group, an alkoxy group, or an aryloxy group, X³⁷¹, Y³⁷¹, and Z³⁷¹ are independently a saturated or unsaturated hydrocarbon group, an aromatic group, a heterocyclic group, a substituted amino group, an alkoxy group, or an aryloxy group, the substituents for Z³⁷¹ and Z³⁷² may be bonded to form a condensed ring, n is an integer of 1 to 3, provided that the Z³⁷¹s may differ when n is 2 or more, and a case in which n is 1, X³⁷¹, Y³⁷¹, and R³⁷² are methyl groups, and R³⁷⁸ is a hydrogen atom or a substituted boryl group, and a case in which n is 3 and Z³⁷¹ is a methyl group are excluded.

Compounds of the following formula disclosed in JP-A-10-088121 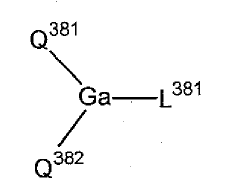 wherein Q³⁸¹ and Q³⁸² are independently a ligand of the following formula, L³⁸¹ is a halogen atom, a substituted or unsubstituted alkyl group, a substituted or unsubstituted cycloalkyl group, a substituted or unsubstituted aryl group, a substituted or unsubstituted heterocyclic ring group, -OR³⁹¹ (R³⁹¹ is a hydrogen atom, a substituted or unsubstituted alkyl group, a substituted or unsubstituted cycloalkyl group, a substituted or unsubstituted aryl group, or a substituted or unsubstituted heterocyclic group), or a ligand of-O-Ga-Q³⁹¹(Q³⁹²) (Q³⁹¹ and Q³⁹² have the same meanings as Q³⁸¹ and Q³⁸²).

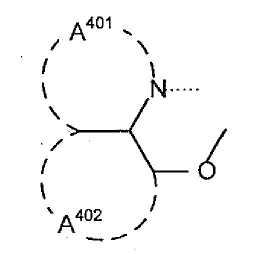

wherein the rings A⁴⁰¹ and A⁴⁰² are bonded and are a substituted or unsubstituted aryl ring or a heterocyclic ring structure.

Specific examples of the substituents for the rings A⁴⁰¹ and A⁴⁰² forming the ligand of the above formula include halogen atoms such as chlorine, bromine, iodine, and fluorine, substituted or unsubstituted alkyl groups such as a methyl group, ethyl group, propyl group, butyl group, sec-butyl group, tert-butyl group, pentyl group, hexyl group, heptyl group, octyl group, stearyl group, and trichloromethyl group, substituted or unsubstituted aryl groups such as a phenyl group, naphthyl group, 3-methylphenyl group, 3-methoxyphenyl group, 3-fluorophenyl group, 3-trichloromethylphenyl group, 3-trifluoromethylphenyl group, and 3-nitrophenyl group, substituted or unsubstituted alkoxy groups such as a methoxy group, n-butoxy group, tert-butoxy group, trichloromethoxy group, trifluoroethoxy group, pentafluoropropoxy group, 2,2,3,3-tetrafluoropropoxy group, 1,1,1,3,3,3-hexafluoro-2-propoxy group, and 6-(perfluoroethyl)hexyloxy group, substituted or unsubstituted aryloxy groups such as a phenoxy group, p-nitrophenoxy group, p-tert-butylphenoxy group, 3-fluorophenoxy group, pentafluorophenyl group, and 3-trifluoromethylphenoxy group, substituted or unsubstituted alkylthio groups such as a methylthio group, ethylthio group, tert-butylthio group, hexylthio group, octylthio group, and trifluoromethylthio group, substituted or unsubstituted arylthio groups such as a phenylthio group, p-nitrophenylthio group, p-tert-butylphenylthio group, 3-fluorophenylthio group, pentafluorophenylthio group, and 3-trifluoromethylphenylthio group, a cyano group, a nitro group, an amino group, mono- or di-substituted amino groups such as a methylamino group, diethylamino group, ethylamino group, diethylamino group, dipropylamino group, dibutylamino group, and diphenylamino group, acylamino groups such as a bis (acetoxymethyl) amino group, bis(acetoxyethyl)amino group, bis(acetoxypropyl)amino group, and bis(acetoxybutyl)amino group, a hydroxyl group, a siloxy group, an acyl group, carbamoyl groups such as a methylcarbamoyl group, dimethylcarbamoyl group, ethylcarbamoyl group, diethylcarbamoyl group, propylcarbamoyl group, butylcarbamoyl group, and phenylcarbamoyl group, a carboxylic acid group, a sulfonic acid group, an imide group, cycloalkyl groups such as a cyclopentane group and a cyclohexyl group, aryl groups such as a phenyl group, naphthyl group, biphenyl group, anthranyl group, phenanthryl group, fluorenyl group, and pyrenyl group, heterocyclic groups such as a pyridinyl group, pyrazinyl group, pyrimidinyl group, pyridazinyl group, triazinyl group, indolinyl group, quinolinyl group, acridinyl group, pyrrolidinyl group, dioxanyl group, piperidinyl group, morpholidinyl group, piperazinyl group, carbazolyl group, furanyl group, thiophenyl group, oxazolyl group, oxadiazolyl group, benzooxazolyl group, thiazolyl group, thiadiazolyl group, benzothiazolyl group, triazolyl group, imidazolyl group, and benzimidazolyl group, and the like. The above substituents may be bonded to form a six-membered aryl ring or heterocyclic ring.

### [Electron-injecting layer]

The electron-injecting layer is a layer for helping the injection of electrons into an emitting layer, and has a large electron mobility. An adhesion improving layer is a layer made of a material particularly good in adhesion to a cathode among such electron-injecting layers.

A preferred embodiment of the invention is a device containing a reducing dopant in an interfacial region between its electron transferring region or cathode and organic layer. The reducing dopant is defined as a substance which can reduce an electron transferring compound. Accordingly, various substances which have given reducing properties can be used. For example, at least one substance can be preferably used which is selected from the group consisting of alkali metals, alkaline earth metals, rare earth metals, alkali metal oxides, alkali metal halides, alkaline earth metal oxides, alkaline earth metal halides, rare earth metal oxides, rare earth metal halides, alkali metal organic complexes, alkaline earth metal organic complexes, and rare earth metal organic complexes.

More specific examples of the preferred reducing dopants include at least one alkali metal selected from the group consisting of Na (work function: 2.36 eV), K (work function: 2.28 eV), Rb (work function: 2.16 eV) and Cs (work function: 1.95 eV), and at least one alkaline earth metal selected from the group consisting of Ca (work function: 2.9 eV), Sr (work function: 2.0 to 2.5 eV), and Ba (work function: 2.52 eV). Metals having a work function of 2. 9 eV or less are particularly preferred. Among these, a more preferable reducing dopant is at least one alkali metal selected from the group consisting of K, Rb and Cs. Even more preferable is Rb or Cs. Most preferable is Cs. These alkali metals are particularly high in reducing ability. Thus, the addition of a relatively small amount thereof to an electron injecting zone improves the luminance of the organic EL device and make the lifetime thereof long. As the reducing dopant having a work function of 2.9 eV or less, a combination of two or more out of these alkali metals is also preferred. Particularly preferred is a combination containing Cs, for example, combinations of Cs and Na, Cs and K, Cs and Rb, or Cs, Na and K. The combination containing Cs makes it possible to exhibit the reducing ability efficiently. The luminance of the organic EL device can be improved and the lifetime thereof can be made long by the addition thereof to its electron-injecting zone.

In the invention, an electron-injecting layer made of an insulator or a semiconductor may further be provided between a cathode and an organic layer. By providing the layer, current leakage can be effectively prevented to improve the injection of electrons. As the insulator, at least one metal compound selected from the group consisting of alkali metal calcogenides, alkaline earth metal calcogenides, halides of alkali metals and halides of alkaline earth metals can be preferably used. When the electron-injecting layer is formed of the alkali metal calcogenide or the like, the injection of electrons can be preferably further improved. Specifically preferable alkali metal calcogenides include Li₂O, LiO, Na₂S, Na₂Se and NaO and preferable alkaline earth metal calcogenides include CaO, BaO, SrO, BeO, BaS and CaSe. Preferable halides of alkali metals include LiF, NaF, KF, LiCl, KCl and NaCl. Preferable halides of alkaline earth metals include fluorides such as CaF₂, BaF₂, SrF₂, MgF₂ and BeF₂ and halides other than fluorides.

Examples of the semiconductor for forming an electron-injecting layer include oxides, nitrides or oxynitrides containing at least one element selected from Ba, Ca, Sr, Yb, Al, Ga, In, Li, Na, Cd, Mg, Si, Ta, Sb and Zn, and combinations of two or more thereof. The inorganic compound for forming an electron-injecting layer is preferably a microcrystalline or amorphous insulating thin film. When an electron-injecting layer is formed of the insulating thin film, a more uniform thin film can be formed to reduce pixel defects such as dark spots. Examples of such an inorganic compound include the above-mentioned alkali metal calcogenides, alkaline earth metal calcogenides, halides of alkali metals, and halides of alkaline earth metals.

### [Cathode]

For the cathode, in order to inject electrons to an electron injecting/transporting layer or emitting layer, the following electrode substance may be used: metals, alloys or electroconductive compounds, or mixtures thereof which have a small work function (4 eV or less). Specific examples of the electrode substance include sodium, sodium-potassium alloy, magnesium, lithium, magnesium/silver alloy, aluminum/aluminum oxide, aluminum/lithium alloy, indium, and rare earth metals.

This cathode can be formed by making the electrode substances into a thin film by vapor deposition, sputtering or some other method.
In organic EL device of upper surface emission or top emission type, a cathode preferably has a transmittance of 10% or more to emitted light.
The sheet resistance of the cathode is preferably several hundreds Ω/□ or less, and the film thickness thereof is usually from 10 nm to 1 µm, preferably from 50 to 200 nm.

### [Insulating layer]

In the organic EL device, pixel defects due to leakage or a short circuit are easily generated since an electric field is applied to super thin films. In order to prevent this, it is preferred to insert an insulator thin layer between a pair of electrodes.

Examples of the material used in the insulating layer include aluminum oxide, lithium fluoride, lithium oxide, cesium fluoride, cesium oxide, magnesium oxide, magnesium fluoride, calcium oxide, calcium fluoride, cesium fluoride, cesium carbonate, aluminum nitride, titanium oxide, silicon oxide, germanium oxide, silicon nitride, boron nitride, molybdenum oxide, ruthenium oxide, and vanadium oxide.
A mixture or laminate thereof may be used.

### [Example of fabricating organic EL device]

The organic EL device can be fabricated by forming an anode, an emitting layer, optionally forming a hole-injecting layer, a hole-transporting layer, an electron-transporting layer and an electron-injecting layer if necessary, and further forming a cathode by use of the materials and methods exemplified above.
The organic EL device can be fabricated in the order reverse to the above, i.e., the order from a cathode to an anode.

An example of the fabrication of the organic EL device will be described below which has a structure wherein the following are successively formed on a transparent substrate: anode/hole-transporting layer/emitting layer/electron-transporting layer/cathode.
First, a thin film made of an anode material is formed into a thickness of 1 µm or less, preferably 10 to 200 nm on an appropriate transparent substrate by vapor deposition, sputtering or some other method, thereby forming an anode. Next, a hole-transporting layer is formed on this anode. As described above, the hole-transporting layer can be formed by vacuum deposition, spin coating, casting, LB technique, or some other method. Vacuum deposition is preferred since a homogenous film is easily obtained and pinholes are not easily generated. In the case where the hole-transporting layer is formed by vacuum deposition, conditions for the deposition vary depending upon a compound used (a material for the hole-transporting layer), a desired crystal structure or recombining structure of the hole-transporting layer, and others. In general, the conditions are preferably selected from the following: deposition source temperature of 50 to 450°C, vacuum degree of 10⁻⁷ to 10⁻³ torr, vapor deposition rate of 0.01 to 50 nm/second, substrate temperature of -50 to 300°C, and film thickness of 5 nm to 5 µm.

Next, an emitting layer is formed on the hole-transporting layer. The emitting layer can also be formed by making a desired organic luminescent material into a thin film by vacuum deposition, sputtering, spin coating, casting or some other method. Vacuum deposition is preferred since a homogenous film is easily obtained and pinholes are not easily generated. In the case where the emitting layer is formed by vacuum deposition, conditions for the deposition, which vary depending on a compound used, can be generally selected from conditions similar to those for the hole-transporting layer.

Next, an electron-transporting layer is formed on this emitting layer. Like the hole-transporting layer and the emitting layer, the layer is preferably formed by vacuum deposition because a homogenous film is required. Conditions for the deposition can be selected from conditions similar to those for the hole-transporting layer and the emitting layer.
Lastly, a cathode is stacked thereon to obtain an organic EL device.

The cathode is made of a metal, and vapor deposition or sputtering may be used. However, vacuum deposition is preferred in order to protect underlying organic layers from being damaged when the cathode film is formed.
For the organic EL device fabrication that has been described above, it is preferred that the formation from the anode to the cathode is continuously carried out, using only one vacuuming operation.

The method for forming each of the layers in the organic EL device of the invention is not particularly limited. A known forming method, such as vacuum deposition, molecular beam deposition, spin coating, dipping, casting, bar coating or roll coating can be used.

The film thickness of each of the organic layers in the organic EL device of the invention is not particularly limited. In general, defects such as pinholes are easily generated when the film thickness is too small. Conversely, when the film thickness is too large, a high applied voltage becomes necessary, leading to low efficiency. Usually, the film thickness is preferably in the range of several nanometers to one micrometer.
If a voltage is applied to the organic EL device, emission can be observed when the polarities of the anode and the cathode are positive and negative, respectively, and a voltage of 3 to 40 V is applied. When a voltage with an opposite polarity is applied, no electric current flows and hence, emission does not occur. If an AC voltage is applied, uniform emission can be observed only when the cathode and the anode have a positive polarity and a negative polarity, respectively. The waveform of the AC applied may be arbitrary.

### Examples

The invention is described specifically using examples. The invention is not limited to these examples.

### Example 1

A transparent electrode made of an indium tin oxide with a thickness of 120 nm was provided on a grass substrate measuring 25 mm by 75 mm by 0.7 mm. The grass substrate was subjected to ultrasonic cleaning with isopropyl alcohol for 5 minutes, and cleaned with ultraviolet ozone for 30 minutes. The resultant substrate was mounted in a vacuum deposition device.

N',N"-bis[4-(diphenylamino)phenyl]-N',N"-diphenylbiphenyl-4,4'-diamine was deposited to form a 60 nm thick film as an hole-injecting layer on the substrate. Thereafter N,N'-bis[4'-{N-(naphthyl-1-yl)-N-phenyl}aminobiphenyl-4-yl]-N-phenylamine was deposited to form a 10 nm thick film as a hole-transporting layer thereon. Next, the compound (A-1) of a naphthacene derivative shown below and the compound (B) of an indenoperylene derivative shown below were co-deposited such that the weight ratio of (A-1) to (B) was 40 to 0.4, to form a 40 nm thick film as an emitting layer.

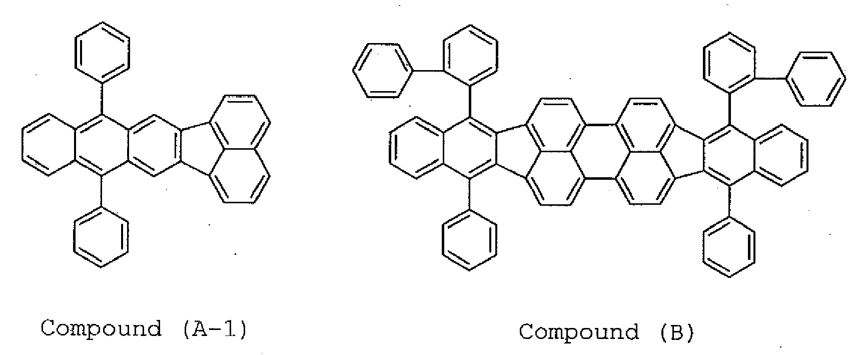

Next, the compound (C) was deposited to form a 30 nm thick film as an electron-transporting layer.

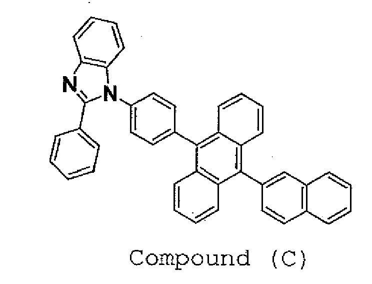

Next, lithium fluoride was deposited to form a 0.3 nm thick film, and then aluminum was deposited to form a 150 nm thick film. This aluminum/lithium fluoride functioned as a cathode. An organic EL device was thus fabricated.

For the device thus obtained, a current test was performed. Red emission with a driving voltage of 4.1 V and luminance of 829 cd/m² was obtained at a current density of 10 mA/cm². The chromaticity coordinates were (0.67, 0.33) and the efficiency was 8.29 cd/A. A direct current continuous test was performed at an initial luminance of 5000 cd/m², and a period of time until the luminance reached 80% of the initial luminance was 3200 hours.

### Example 2

An organic EL device was fabricated in the same manner as in Example 1 except that the compound (A-2) of a naphthacene derivative, was used instead of the compound (A-1) when an emitting layer was formed.

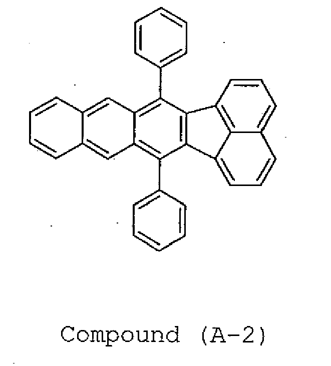

For the device thus obtained, a current test was performed. Red emission with a driving voltage of 4.0 V and luminance of 776 cd/m² was obtained at a current density of 10 mA/cm². The chromaticity coordinates were (0.67, 0.33) and the efficiency was 7.76 cd/A. When a direct current continuous test was performed at an initial luminance of 5,000 cd/m², a half life was 3,400 hours.

### Comparative Example 1

An organic EL device was fabricated in the same manner as in Example 1 except that the compound (A-3) was used instead of compound (A-1) when an emitting layer was formed.

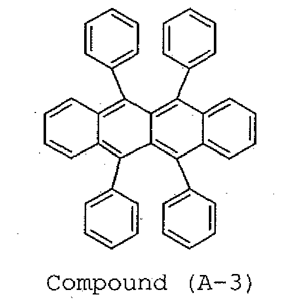

For the device thus obtained, a current test was performed. Red emission with a driving voltage of 4.5 V and luminance of 692 cd/m² was obtained at a current density of 10 mA/cm². The chromaticity coordinates were (0.66, 0.33) and the efficiency was 6.92 cd/A. A direct current continuous test was performed at an initial luminance of 5000 cd/m², and a half life was 1500 hours.

**Table 1**

| | Driving voltage (V) | Luminance (cd/m²) | Chromaticity coordinate | Luminous efficiency (cd/A) | Driving time (hr) |
|---|---|---|---|---|---|
| Example 1 | 4.1 | 829 | (0.67, 0.33) | 8.29 | 3200 |
| Example 2 | 4.0 | 776 | (0.67, 0.33) | 7.76 | 3400 |
| Comparative Example 1 | 4.5 | 692 | (0.66, 0.33) | 6.92 | 1500 |

### Industrial Applicability

The organic EL device of the invention can be used in the fields of various displays, back light, light source, indicators, signboards, interiors and the like, and is particularly suitable for display devices of color displays.

## Claims

1. An organic electroluminescence device comprising:
an anode,
a cathode, and
at least an emitting layer and an electron-transporting layer provided between the anode and the cathode;
the emitting layer containing a host material which is a fluoranthene derivative represented by the following formula (1) and a dopant material which is an indenoperylene derivative: 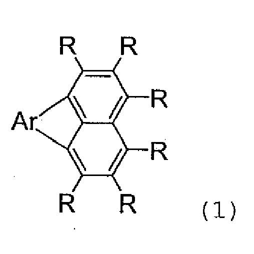 wherein Ar is a substituted or unsubstituted aromatic group having 6 to 50 ring carbon atoms; and Rs are independently a hydrogen atom, a substituted or unsubstituted aromatic group having 6 to 50 ring carbon atoms, a substituted or unsubstituted aromatic heterocyclic group having 5 to 50 ring atoms, or a substituted or unsubstituted alkyl group having 1 to 50 carbon atoms.

2. The organic electroluminescence device according to claim 1 wherein the fluoranthene derivative is a compound represented by the following formula (2) or (3): 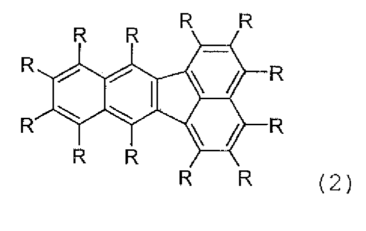 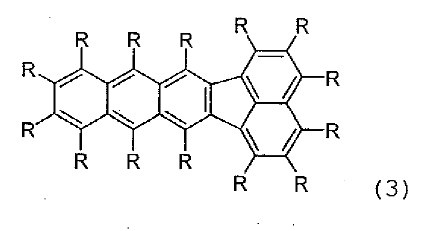 wherein Rs are independently a hydrogen atom, a substituted or unsubstituted aromatic group having 6 to 50 ring carbon atoms, a substituted or unsubstituted aromatic heterocyclic group having 5 to 50 ring atoms or a substituted or unsubstituted alkyl group having 1 to 50 carbon atoms.

3. The organic electroluminescence device according to claim 1 or 2 wherein the indenoperylene derivative is a compound represented by the following formula (4) or (5): 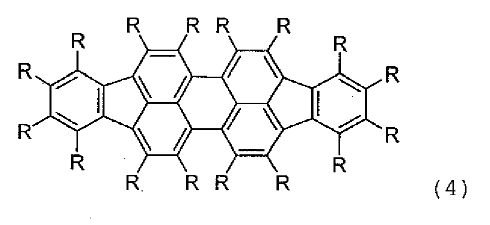 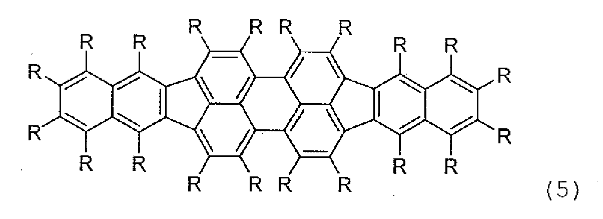 wherein Rs are independently a hydrogen atom, a substituted or unsubstituted aromatic group having 6 to 50 ring carbon atoms, a substituted or unsubstituted aromatic heterocyclic group having 5 to 50 ring atoms, or a substituted unsubstiuted alkyl group having 1 to 50 carbon atoms.

4. The organic electroluminescence device according to any one of claims 1 to 3 wherein the electron-transporting layer contains a compound represented by the following formula (6):
(A)ᵤ-(B)ᵥ (6)
wherein A is an aromatic hydrocarbon group with 3 or more carboncircles; B is a heterocyclic group which may be substituted; and u and v are each an integer of 1 to 6.

5. The organic electroluminescence device according to claim 4 wherein the compound represented by the formula (6) is a compound containing in the molecule thereof at least one skeleton selected from anthracene, phenanthrene, naphthacene, pyrene, chrysene, benzoanthracene, pentacene, dibenzoanthracene, benzopyrene, fluorene, benzofluorene, fluoranthene, benzofluoranthene, naphthofluoranthene, dibenzofluorene, dibenzopyrene and dibenzofluoranthene.

6. The organic electroluminescence device according to claim 4 or 5 wherein the compound represented by the formula (6) is a nitrogen-containing heterocyclic compound.

7. The organic electroluminescence device according to claim 6 wherein the nitrogen-containing heterocyclic compound is a compound containing in the molecule thereof at least one skeleton selected from pyridine, pyrimidine, pyrazine, pyridazine, triazine, quinoline, quinoxaline, acridine, imidazopyridine, imidazopyrimidine and phenenthroline.

8. The organic electroluminescence device according to claim 6 wherein the nitrogen-containing heterocyclic compound is a benzoimidazole derivative represented by the following formula (7) or (8): 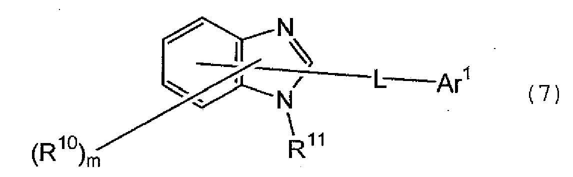 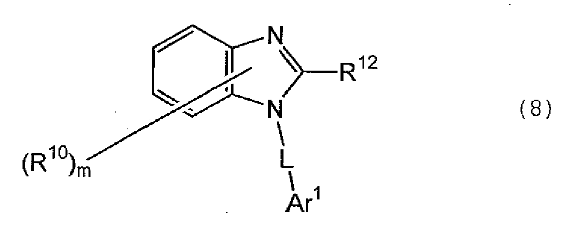 wherein R¹⁰ is a hydrogen atom, a substituted or unsubstituted aryl group having 6 to 60 carbon atoms, a substituted or unsubstituted pyridyl group, a substituted or unsubstituted quinolyl group, a substituted or unsubstituted alkyl group having 1 to 20 carbon atoms or a substituted or unsubstituted alkoxy group having 1 to 20 carbon atoms;
m is an integer of 0 to 4;
R¹¹ is a substituted or unsubstituted aryl group having 6 to 60 carbon atoms, a substituted or unsubstituted pyridyl group, a substituted or unsubstituted quinolyl group, a substituted or unsubstituted alkyl group having 1 to 20 carbon atoms or an alkoxy group having 1 to 20 carbon atoms;
R¹² is a hydrogen atom, a substituted or unsubstituted aryl group having 6 to 60 carbon atoms, a substituted or unsubstituted pyridyl group, a substituted or unsubstituted quinolyl group, a substituted or unsubstituted alkyl group having 1 to 20 carbon atoms, or a substituted or unsubstituted alkoxy group having 1 to 20 carbon atoms;
L is a substituted or unsubstituted arylene group having 6 to 60 carbon atoms, a substituted or unsubstituted pyridinylene group, a substituted or unsubstituted quinoliylene group, or a substituted or unsubstituted fluorenylene group; and
Ar¹ is a substituted or unsubstituted aryl group having 6 to 60 carbon atoms, a substituted or unsubstituted pyridinyl group or a substituted or unsubstituted quinolinyl group.

9. The organic electroluminescence device according to any one of claims 1 to 8 wherein the doping concentration of the dopant in the emitting layer is 0.1 to 10 wt%.

10. The organic electroluminescence device according to claim 9 wherein the doping concentration of the dopant in the emitting layer is 0.5 to 2 wt%.

11. The organic electroluminescence device according to any one of claims 1 to 10 whose emission color is orange to red.

12. An apparatus comprising the organic electroluminescet device of any one of claims 1 to 11.
